# EUROPÄISCHE PATENTANMELDUNG

(11) **EP 1 743 956 A2**
(43) Veröffentlichungstag der Anmeldung: **17.01.2007**
(21) Anmeldenummer: 06116958.7
(22) Anmeldetag: 11.07.2006
(51) Int. Cl.: C23C 28/02, C23C 2/06, C23C 14/16, C23C 14/58

(54) **Verfahren zur Herstellung von korrosionsgeschütztem Stahlblech**

(30) Priorität: 15.07.2005 DE 102005033773
(71) Anmelder: ThyssenKrupp Steel AG, 47166 Duisburg (DE)
(72) Erfinder: Schwerdt, Christian, 47051, Duisburg (DE); Stahl, Jürgen, Dr., 46535, Dinslaken (DE); Schuhmacher, Bernd, Dr., 44227, Dortmund (DE)
(74) Vertreter: Cohausz & Florack

(57) **Zusammenfassung**

Die vorliegende Erfindung betrifft ein Verfahren zur Herstellung von korrosionsgeschütztem Stahlblech, bei dem auf ein Stahlblech eine erste metallische Überzugsschicht aufgebracht wird, bei dem auf das mit der ersten metallischen Überzugsschicht versehene Stahlblech eine zweite metallische Überzugsschicht aufgebracht wird und bei dem nach dem Aufbringen der zweiten Überzugsschicht eine thermische Nachbehandlung des beschichteten Stahlblechs zur Ausbildung einer Diffusions- oder Konvektionsschicht durchgeführt wird. Durch das erfindungsgemäße Verfahren lässt sich auch großtechnisch kostengünstig korrosionsgeschütztes Stahlfeinblech herstellen, welches die Vorteile von reinen Zinküberzügen, wie große kathodische Schutzwirkung, hohe Duktilität und geringer Abrieb bei Umformung, verbindet mit den Vorteilen von Überzügen aus Zinklegierungen, wie gute Punktschweißbarkeit, gute Phosphatierbarkeit und Lackhaftung. Dies wird dadurch erreicht, dass das Stahlblech mit seinen Überzugsschichten im Zuge der thermischen Nachbehandlung durch auf mindestens eine seiner Oberflächen gerichtete Strahlungsenergie von hoher Energiedichte nur in einer an die von der Strahlungsenergie erfasste Oberfläche angrenzenden Schicht auf die für die Bildung der Diffusions- oder Konvektionsschicht erforderliche Temperatur erwärmt wird.

## Beschreibung

Die Erfindung betrifft ein Verfahren zur Herstellung von korrosionsgeschütztem Stahlblech, bei dem auf ein Stahlblech eine erste metallische Überzugsschicht aufgebracht wird, bei dem auf das mit der ersten metallischen Überzugsschicht versehene Stahlblech, vorzugsweise mittels Dampfphasenabscheidung, eine zweite metallische Überzugsschicht aufgebracht wird und bei dem nach dem Aufbringen der zweiten Überzugsschicht eine thermische Nachbehandlung des beschichteten Stahlblechs zur Ausbildung einer Diffusions- oder Konvektionsschicht durchgeführt wird.

Derartige Verfahren werden beispielsweise zur Herstellung von Stahlfeinblechen eingesetzt, die aufgrund ihrer optimierten Korrosionsbeständigkeit besonders zur Verwendung im Bereich der Bau-, der Haushaltsgeräte- oder der Automobilindustrie geeignet sind.

Es ist bekannt, aus Gründen des Korrosionsschutzes auf Stahlbleche Überzüge aufzubringen, die vorzugsweise aus Zink oder Zinklegierungen bestehen. Zinküberzüge bzw. Zinklegierungsüberzüge gewährleisten für Stahlblech aufgrund ihrer Barriere- und kathodischen Schutzwirkung einen sehr guten Korrosionsschutz. Allerdings nehmen trotz der bisher erreichten Qualität die Anforderungen an den Korrosionsschutz durch die Verarbeiter aus z.B. der Automobil-, Bau- und Hausgeräteindustrie ständig zu. Dabei besteht neben einem starken Kostendruck gleichzeitig die Forderung nach einer besseren Verarbeitbarkeit. Diesen Anforderungen kann nicht ohne weiteres mit einer Anhebung der Überzugsdicke begegnet werden, da zum einen wirtschaftliche und ökologische Gründe dagegen sprechen und zum anderen mit der Erhöhung der Überzugsdicke eine generelle Verschlechterung der Eignung derart verzinkter Stahlbleche zur Weiterverarbeitung einhergeht.

Ein zentraler Aspekt der Herstellung von oberflächenveredelten Stahlblechen ist daher die Wirtschaftlichkeit und die Umweltverträglichkeit des Herstellungsprozesses. Speziell bei verzinkten Stahlblechen kommen großtechnisch vorzugsweise kontinuierliche Veredelungsverfahren auf Basis des Schmelztauchens oder der elektrolytischen Abscheidung zum Einsatz. Die Durchlaufgeschwindigkeit der jeweils verarbeiteten, üblicherweise bis zu 2,5 m breiten Stahlbänder beträgt dabei bis zu 300 m/min.

Die Weiterverarbeitung der verzinkten Stahlbleche zu Gebrauchsgegenständen erfolgt üblicherweise durch Umformen, Fügen, organisches Beschichten (z.B. Lackieren) oder vergleichbare Prozesse. Entsprechend vielfältig sind die sich ergebenden Anforderungen an die Gebrauchs- und Verarbeitungseigenschaften der verzinkten Stahlbleche. So sind Oberflächenqualität, Umformverhalten, Eignung für unterschiedliche Fügeverfahren (z.B. Punktschweißen, Laserschweißen, Kleben,...), Phosphatierbarkeit, kataphoretische Lackierbarkeit und Lackhaftung wichtige Qualitätsmerkmale korrosionsgeschützter Stahlbleche. Ein weiteres wichtiges Merkmal ist die Umformbarkeit der Überzüge, d.h. deren Fähigkeit, auch stärkeren Umformbeanspruchungen, wie sie beispielsweise beim Tiefziehen auftreten, ohne gravierende Schädigung zu widerstehen. Jede einzelne dieser Forderungen lässt sich mit konventionellen reinverzinkten Produkten nicht im gleichen Maße erfüllen. Vielmehr weisen konventionell beschichte Stahlbleche in der Regel im Bereich eines Anforderungsmerkmals besonders gute Eigenschaften auf, während im Bereich der anderen Anforderungsmerkmale Abstriche hingenommen werden müssen.

So zeichnen sich beispielsweise feuerverzinkte Stahlbleche durch einen hohen Korrosionsschutz im unlackierten wie lackierten Zustand aus. Allerdings können die ständig zunehmenden Anforderungen seitens der Anwender an den Korrosionsschutz in vielen Fällen nicht mehr erfüllt werden, ohne die Überzugsdicke auf ein unvertretbar hohes Maß zu erhöhen. Die Umformbarkeit der Feuerzinküberzüge ist aufgrund der relativ hohen Duktilität des reinen Zinks sehr gut. Das Verfahren der kontinuierlichen Feuerverzinkung ist kostengünstig und umweltschonend. Eine hohe, d.h. für eine Qualitätslackierung geeignete Oberflächenqualität ist bei der kontinuierlichen Feuerverzinkung erreichbar, allerdings nur mit hohem verfahrenstechnischen Aufwand. Was die Punktschweißbarkeit anbelangt, müssen allerdings erheblich geringere Elektrodenstandmengen im Vergleich zu unveredelten Stahlblechen in Kauf genommen werden, dies um so mehr, je höher die Überzugsdicke ist. Zunehmend kommt in der Automobilindustrie auch das Laserschweißen zum Einsatz. Die Laserstrahlschweißeignung wird aber besonders durch das Verdampfen des Zinks negativ beeinflusst. Auch die Phosphatierbarkeit, die kataphoretische Lackierbarkeit und die Lackhaftung von feuerverzinkten Stahlblechen ist deutlich ungünstiger als bei unverzinktem Stahlblech.

Elektrolytisch verzinkte Stahlbleche weisen gegenüber feuerverzinkten Stahlblechen zwar im Allgemeinen eine bessere Oberflächenqualität und eine verbesserte Phosphatierbarkeit auf. Die anderen Nachteile von feuerverzinkten Stahlblechen lassen sich jedoch auch bei elektrolytisch verzinkten Blechen nicht vermeiden. Hinzu kommt, dass die Herstellung von elektrolytisch verzinkten Stahlblechen durch den höheren Energieeinsatz und die erforderlichen Entsorgungsmaßnahmen, die der nasschemische Prozess nach sich zieht, kostenintensiver ist als die Feuerverzinkung.

Eine Verbesserung der Gebrauchseigenschaften von verzinkten Stahlblechen kann dadurch erzielt werden, dass auf die erste, durch die Verzinkung gebildete Veredelungsschicht eine zweite Schicht aufgetragen wird. Durch den Auftrag dieser zweiten Schicht wird eine Eigenschaftskombination erreicht, bei der sich die Eigenschaften der ersten Schicht und der zweiten Schicht optimal ergänzen.

Verfahren, die den Auftrag einer solchen zweiten Schicht auf ein zuvor mit einer vor Korrosion schützenden Beschichtung versehenen Stahlblechen ermöglichen, sind beispielsweise aus der DE 195 27 515 C1 bzw. EP 0 756 022 B1 oder der DE 100 39 375 A1 bzw. WO 02/14573 bekannt. Die nach diesen Verfahren hergestellten korrosionsgeschützten Stahlfeinbleche weisen eine verbesserte Umform- und Punktschweißbarkeit auf. Dazu wird eine mittels verschiedener Prozesse der physikalischen Dampfphasenabscheidung auf dem zuvor zinkbeschichteten Stahlsubstrat abgeschiedene Deckschicht durch eine Wärmebehandlung in Inertgas- bzw. sauerstoffarmer Atmosphäre in die zinkhaltige Korrosionsschutzschicht eindiffundiert.

Nachteilig ist bei dieser Vorgehensweise vor allem die relativ lange Prozesszeit von mindestens 10 Sekunden, was bei Behandlung von Stahlband im Durchlaufverfahren aufgrund der dafür erforderlichen großen Behandlungsapparaturen hohe Zusatzkosten verursachen würde. Übliche Durchlaufgeschwindigkeiten liegen derzeit bei oder über 100 m/min. Dementsprechend müsste die Inertgaskammer eine Länge von über 16 m haben. An diese Inertgaskammer müsste sich dann auch noch eine erste Kühlstrecke anschließen. In dieser müsste das Stahlband ohne weitere Führungsrollen frei hängen können, da ansonsten Verklebung mit den Rollen und/oder eine Beschädigung der zinkhaltigen Schicht unvermeidlich wären.

Neben den aus den bekannten Verfahren resultierenden hohen Investitionskosten würden im Betrieb hohe laufende Kosten anfallen, die durch den hohen Gas- und Energieverbrauch verursacht würden. Derartige Probleme sind auch schon von bestehenden Anlagen für das Legierungsverzinken von Stahlband (Galvannealing) bekannt.

Gemäß einer im Hinblick auf die Schutzwirkung der Beschichtung vorteilhaften Ausgestaltung des aus der DE 195 27 515 C1 bekannten Verfahrens wäre es von Vorteil, den Diffusionsprozess im Vakuum oder zumindest im Grobvakuum durchzuführen. In der Praxis zeigt sich jedoch, dass dies nicht zu realisieren ist, da die Abkühlung des Bandes im Vakuum auf eine Temperatur, die ein Ausschleusen des Bandes aus dem Vakuum ermöglichen würde, zu lang sind. Aus diesen Gründen erweist sich das aus der DE 195 27 515 C1 bekannte Verfahren trotz der erreichten Eigenschaftsverbesserungen für eine wirtschaftliche Massenproduktion nicht als geeignet.

Ausgehend von dem voranstehend erläuterten Stand der Technik lag der Erfindung die Aufgabe zugrunde, ein auch großtechnisch kostengünstig durchführbares Verfahren zur Herstellung von korrosionsgeschütztem Stahlfeinblech zu schaffen, welches die Vorteile von reinen Zinküberzügen, wie große kathodische Schutzwirkung, hohe Duktilität und geringer Abrieb bei Umformung, verbindet mit den Vorteilen von Überzügen aus Zinklegierungen, wie gute Punktschweißbarkeit, gute Phosphatierbarkeit und Lackhaftung.

Diese Aufgabe ist durch ein Verfahren der eingangs angegebenen Art dadurch gelöst worden, dass erfindungsgemäß das Stahlblech mit seinen Überzugsschichten im Zuge der thermischen Nachbehandlung durch auf mindestens eine seiner Oberflächen gerichtete Strahlungsenergie von hoher Energiedichte nur in einer an die von der Strahlungsenergie erfasste Oberfläche angrenzenden Schicht auf die für die Bildung der Diffusions- oder Konvektionsschicht erforderliche Temperatur erwärmt wird.

Beim erfindungsgemäßen Verfahren wird anders als beim Stand der Technik das mindestens zweifach beschichtete Stahlband nicht über seine gesamte Dicke auf die für die gewünschte Reaktion erforderliche Temperatur erwärmt, sondern es findet, vorzugsweise im Durchlauf, nur eine konzentrierte, auf eine Oberflächenschicht beschränkte Erwärmung statt. Der überwiegende Teil des Stahlbandvolumens, das dem von der Strahlungsenergie jeweils erfassten Oberflächenabschnitt zugeordnet ist, behält demgegenüber eine Temperatur bei, die deutlich unterhalb der für die Bildung der Diffusions- bzw. Konvektionsschicht erforderlichen Temperatur liegt.

Durch das erfindungsgemäße schnelle, vorzugsweise sequentiell erfolgende Aufheizen eines lateralen Teils der Überzugsschichten und angrenzender Bereiche des Stahlsubstrats mittels Strahlung hoher Energiedichte lässt sich so in erfindungsgemäßer Weise die Zusammensetzung der Schicht modifiziert bzw. durch die folgende Selbstabschreckung durch das Substrat die Struktur der Schicht beeinflussen, ohne dass das Stahlblech insgesamt auf eine für solche Prozesse notwendige Temperatur gebracht werden muss. Beeinflussungen der Eigenschaften des Stahlsubstrats selbst können so sicher vermieden werden. Darüber hinaus lässt sich die erfindungsgemäße Vorgehensweise problemlos so durchführen, dass nur die von der Erwärmung jeweils erfasste Seite des Stahlbands beeinflusst wird, während die andere Seite unbehandelt bleibt.

Zur Durchführung des erfindungsgemäßen Verfahrens wird als Ausgangsmaterial ein Stahlblech eingesetzt, welches beispielsweise als Feinblech in Bandform vom Coil abgewickelt oder direkt aus einer vorangegangenen Bearbeitungsstation zugeführt wird. Dieses im Hinblick auf die angestrebte Wirkung und Verwendung vorzugsweise kohlenstoffarme Stahlblech ist bereits mit einem vorzugsweise aus Zink oder einer Zinklegierung mit einem Anteil von vorzugsweise 80 Masse-% Zink bestehenden metallischen Überzug versehen, dessen Dicke zur Sicherstellung des angestrebten Korrosionsschutzes bevorzugt im Bereich von 2 bis 20 µm liegt. Die Verzinkung kann dabei galvanisch, mittels eines PVD-Verfahrens (Physical Vapour Deposition - physikalische Dampfabscheidung), im Tauchbad oder in anderer geeigneter Weise erfolgen.

Nachdem das mit der metallischen Beschichtung versehene Stahlband erforderlichenfalls einer nasschemischen Entfettung und einer Plasmafeinreinigung unterzogen worden ist, wird vorzugsweise in einem Dampfabscheideverfahren, z.B. einem konventionellen PVD-Verfahren, eine Deckschicht auf dem beschichteten Stahlsubstrat abgeschieden. Bei der praktischen Anwendung liegt die Dicke der auf diese Weise erzeugten zweiten Überzugsschicht bevorzugt bei 0,1 bis 2 µm, um deren gewünschte Wirkung sicher zu erhalten.

Für die anschließend erfolgende Diffusionsbehandlung wird dann Strahlung hoher Energiedichte eingesetzt. Der in das beschichtete Stahlsubstrat eingebrachte Energieeintrag wird dabei so gewählt, dass nur eine oberflächennahe Schicht geringer Dicke von vorzugsweise 1 bis 20 µm auf die für die angestrebte Diffusion bzw. Konvektion erforderliche Temperatur gebracht wird. Dabei sind Behandlungszeiten < 100 ms zu wählen, um einen übermäßigen Energieverlust aufgrund der guten Wärmeleitung, vor allem auch der kohlenstoffarmen Stähle und damit eine deutliche Aufheizung des Substrates zu vermeiden. Hierzu sind Leistungsdichten > 1 * 10⁵ W/m² einzusetzen.

Die für diese Aufheizung erforderliche Zeit ist so kurz, dass sie problemlos auch bei hohen Durchlaufgeschwindigkeiten durchgeführt werden kann. Überraschend ergab sich, dass der über eine derart kurze Einwirkzeit erfolgende konzentrierte Energieeintrag ausreicht, um eine Schichtbildung über Diffusion bzw. Konvektion zu erreichen.

Nach der Beendigung der Heizphase verteilt sich die zugeführte Energiemenge innerhalb weniger 100 ms gleichmäßig über die gesamte Dicke des Substrats. So können erfindungsgemäß Abkühlzeiten im Bereich von < 1 s garantiert werden. Am Ende dieser Abkühlung weist das Stahlband in erster Näherung nur eine Temperaturerhöhung auf, die dem Verhältnis von behandelter Schichtdicke zu, bei beidseitiger Behandlung halber, Banddicke mal dem angewandten Temperaturhub entspricht. Aufgrund dieser geringen Temperaturerhöhung ist in der Regel allenfalls eine geringe bzw. gar keine aktive Kühlung nach der thermischen Nachbehandlung mehr erforderlich, bevor das Band mit einem Führungselement, beispielsweise einer Rolle, in Berührung kommt.

Der Eintrag der Strahlenenergie zum Aufheizen der oberflächennahen Schicht des mit der Beschichtung versehenen Substrats kann beispielsweise dadurch erfolgen, dass das Stahlband nach Durchlauf der PVD-Beschichtung mittels eines leistungsstarken Elektronenstrahls aufgeheizt wird, dessen Durchmesser zur Erzielung der erforderlichen Energiedichte im Auftreffpunkt beispielsweise auf unter 5 mm fokussiert ist.

Gemäß einer alternativen Möglichkeit der erfindungsgemäßen Aufheizung wird ein Laser, vorzugsweise ein Diodenlaserarray, verwendet, um das Stahlband schnell und konzentriert zu erwärmen. In diesem Fall lassen sich die Art der Umgebungsatmosphäre und der Atmosphärendruck allein im Hinblick auf das Verhalten des Stahlblechs und bzw. seiner Beschichtungen während des Aufheizens frei wählen.

Die Erwärmung während der thermischen Nachbehandlung kann dabei mittels linearer oder quasi linearer Fokussierung der Strahlungsenergie auf das Material erfolgen.

Um eine möglichst intensive Wirkung der Strahlungsenergie bei einer gleichzeitig minimierten Behandlungsdauer zu erreichen, kann der die Strahlungsenergie abgebende Energiestrahl im Wesentlichen senkrecht zur behandelten Oberfläche ausgerichtet werden. Auf diese Weise lässt sich eine insgesamt gleichmäßige Modifikation der Veredelungsschicht besonders sicher gewährleisten.

Mit der Erfindung steht demzufolge ein Verfahren zur Verfügung, dass eine kostengünstige Herstellung von korrosionsgeschütztem Stahlfeinblech ermöglicht, das eine gegenüber reinen Zinküberzügen verbesserte Eigenschaftskombination besitzt, wie eine große kathodische Schutzwirkung, eine hohe Duktilität, einen geringen Abrieb beim Umformen, eine gute Punktschweißbarkeit, eine gute Phosphatierbarkeit und eine gute Lackhaftung. Dabei lässt sich das erfindungsgemäße Verfahren mit einem gegenüber den bekannten Verfahren minimierten Energieaufwand betreiben. So können mit der Erfindung gegenüber der konventionellen Vorgehensweise bei der Beschichtung Energieeinsparungen von mehr als 90 % realisiert werden. Darüber hinaus kann ein erfindungsgemäß beschichtetes Band ohne zusätzliche Nachbearbeitung direkt der Weiterverarbeitung zugeführt werden. Ein zusätzlicher Aufwand, wie beispielsweise ein zusätzliches Dressieren zum Ausgleich von im Zuge der beim Stand der Technik unvermeidbaren Durcherwärmung auftretenden Veränderungen der mechanisch/technologischen Eigenschaften des Bandes, sind nicht mehr erforderlich.

Aufgrund der kurzen Behandlungs- und Einwirkdauer kann die erfindungsgemäß durchgeführte thermische Nachbehandlung auch großtechnisch unter sauerstoffarmer oder inerter Atmosphäre sowie erforderlichenfalls auch unter Vakuum durchgeführt werden, da keine langen Diffusionsstrecken benötigt werden. Da erfindungsgemäß nur eine dünne Oberflächenschicht erwärmt wird und die in die Oberflächenschicht eingebrachte Wärme sich innerhalb kürzester Zeit über das gesamte Substratvolumen verteilt, ist nach der thermischen Nachbehandlung keine oder nur eine sehr geringere Kühlung nötig. Die beim erfindungsgemäßen Verfahren erzielten extrem hohen Kühlraten ermöglichen vielmehr Schichteigenschaften, bis hin zu amorphen Schichten, die bei einer klassischen Durchheizung des Bandes nicht zu verwirklichen sind.

Schließlich minimieren die geringen Abmessungen der für die Durchführung des erfindungsgemäßen Verfahrens benötigten Anlagen nicht nur die Investitionskosten, sondern ermöglichen vor allem auch eine einfachere Integration des Verfahrens in bereits vorhandene Anlagen.

Der schnelle Verfahrensablauf und die Möglichkeit der Begrenzung der Wirkung der erfindungsgemäß durchgeführten thermischen Nachbehandlungen auf eine bestimmte Oberfläche des Stahlblechs erlauben es, die erfindungsgemäße thermische Nachbehandlung beidseitig mit gleichen oder unterschiedlichen Parametern durchzuführen. Auf diese Weise lassen sich Stahlbleche erzeugen, deren Oberflächenbeschaffenheit an die sich bei ihrer praktischen Verwendung stellenden Anforderungen optimal angepasst sind.

Sollte sich herausstellen, dass eine einmalige Durchführung der erfindungsgemäßen thermischen Nachbehandlung nicht ausreicht, so kann sie mit den gleichen oder variierten Parametern ein- oder mehrmals wiederholt werden, um das gewünschte Bearbeitungsergebnis zu erzielen.

Auf die erfindungsgemäße Weise lassen sich an der Oberfläche vorhandene oder erzeugte, im Vergleich zur Zinkschicht bzw. zur Zinklegierungsschicht aus der zusätzlich aufgebrachten metallischen Schicht höherschmelzende Oxidschichten herstellen, um eine mögliche Veränderung der Oberflächentopographie weitestgehend einzuschränken.

Dabei lässt sich der Energieeintrag bei der erfindungsgemäß durchgeführten thermischen Nachbehandlung so steuern, dass eine zusätzliche, in Bezug auf die angestrebten Eigenschaften vorteilhafte Legierung der zinkhaltigen Schicht durch Festkörper- und/oder Flüssigphasendiffusion vom Stahlblech her erzeugt wird.

Abhängig von der Reaktivität der Überzugsschichten und des Stahlbands, von dem gewünschten Behandlungsergebnis und von der eingesetzten Strahlungsquelle kann die Atmosphäre gewählt werden, unter der das thermische Nachbehandeln erfindungsgemäß durchgeführt wird. So kann es zweckmäßig sein, die thermische Nachbehandlung im Vakuum oder unter einer Schutzgasatmosphäre durchzuführen, wenn möglichst geringe äußere Einflüsse gewünscht werden. Alternativ kann es jedoch auch zweckmäßig sein, die erfindungsgemäße Wärmebehandlung in einer gezielt reduzierenden bzw. oxidierenden Atmosphäre durchzuführen. Denkbar ist es darüber hinaus, für die erfindungsgemäße thermische Nachbehandlung eine Atmosphäre vorzusehen, welcher chemische Vorprodukte zugesetzt werden, um gezielt eine weitere Funktionalität an der Oberfläche des Schichtpaketes zu erzeugen.

Nachfolgend wird die Erfindung anhand eines Ausführungsbeispiels näher erläutert.

Ein kohlenstoffarmes Stahlfeinblech ist durch konventionelles elektrolytisches Zinkbeschichten mit einer mindestens 80 Masse-% Zink enthaltenden, 7,5 µm dicken ersten Überzugsschicht versehen worden. Anschließend ist das so beschichtete, bandförmige Stahlfeinblech in einem kontinuierlichen Verfahrensablauf ebenfalls auf konventionelle Weise nasschemisch entfettet und einer Plasmafeinreinigung unterzogen worden.

Das derart vorbehandelte Stahlblech hat anschließend ebenfalls im Durchlauf mehrere Druckstufen durchlaufen, bevor es in einer Vakuumsektion eingetroffen ist. Dort ist es in an sich ebenfalls bekannter Weise auf eine der Oberflächen des Stahlfeinblechs in einem PVD-Verfahren mit einer ca. 800 nm dicken, aus Magnesium bestehenden zweiten Überzugsschicht versehen worden.

An das Abscheiden der zweiten Überzugsschicht hat sich eine im kontinuierlichen Durchlauf absolvierte thermische Nachbehandlung unter Vakuum angeschlossen, bei der ein Elektronenstrahl mit einer Ablenkfrequenz von über 1 kHz zeilenweise über die mit den Überzügen versehene Oberfläche des währenddessen kontinuierlich weiter geförderten Stahlfeinblechs hin und her geführt worden ist, so dass sich entsprechend der Wärmeleitung nur eine Erwärmung in den obersten 10 bis 20 µm des Stahlfeinblechs ergeben hat. Die Eindringtiefe der Elektronen ist dabei in weiten Bereichen mittels der Beschleunigungsspannung auf die eingesetzten Überzugsschichtdicken abgestimmt worden. Durch die auf diese Weise eingebrachte Strahlungsenergie ist die oberste Schicht bis auf eine Reaktionstemperatur erwärmt worden, die zwischen 300° und 600°C lag.

Nachdem der zuvor jeweils vom Elektronenstrahl erfasste und auf die Reaktionstemperatur erwärmte Abschnitt des Stahlblechs den Wirkbereich des Elektronenstrahls verlassen hat, hat sich die eingespeiste Wärmeenergie innerhalb weniger 100 ms gleichmäßig über die Banddicke verteilt. Nach Abschluss dieses Ausgleichsprozesses lag die gleichmäßig über die gesamte Dicke des Stahlbands und seiner Überzugsschichten verteilte Temperatur um nicht mehr als 30 K über der Temperatur, mit der das Stahlband in die thermische Nachbehandlung eingetreten ist.

Die Länge des während der gesamten thermischen Nachbehandlung zurückgelegten aus Aufheiz- und Ausgleichsstrecke zusammengesetzten Wegs betrug etwa 30 cm.

Da nur eine dünne Schicht aufgeheizt worden ist, ist die notwendige Energiemenge gering.

Für einen zweiten Versuch ist anstelle einer thermischen Nachbehandlung mittels eines Elektrodenstahls eine Laserbehandlung des Stahlblechs durchgeführt worden, bei der ein Diodenlaserarray eingesetzt worden ist. In diesem Fall ist die Strahlungsenergie parallel zur Bandlaufrichtung über die gesamte Bandbreite in einem linearen Focus von weniger als 3 mm Breite eingebracht worden. Die Behandlungszone konnte so mit der Bandlaufgeschwindigkeit über das verarbeitete Stahlblech bewegt werden.

## Patentansprüche

1. Verfahren zur Herstellung von korrosionsgeschütztem Stahlblech, bei dem auf ein Stahlblech eine erste metallische Überzugsschicht aufgebracht wird, bei dem auf das mit der ersten metallischen Überzugsschicht versehene Stahlblech eine zweite metallische Überzugsschicht aufgebracht wird und bei dem nach dem Aufbringen der zweiten Überzugsschicht eine thermische Nachbehandlung des beschichteten Stahlblechs zur Ausbildung einer Diffusions- oder Konvektionsschicht durchgeführt wird, **dadurch gekennzeichnet, dass** das Stahlblech mit seinen Überzugsschichten im Zuge der thermischen Nachbehandlung durch auf mindestens eine seiner Oberflächen gerichtete Strahlungsenergie von hoher Energiedichte nur in einer an die von der Strahlungsenergie erfasste Oberfläche angrenzenden Schicht auf die für die Bildung der Diffusions- oder Konvektionsschicht erforderliche Temperatur erwärmt wird.

2. Verfahren nach Anspruch 1, **dadurch gekennzeichnet, dass** die erste Überzugsschicht eine Zinkbeschichtung mit mindestens 80 Masse-% Zink ist.

3. Verfahren nach einem der voranstehenden Ansprüche, **dadurch gekennzeichnet, dass** die zweite metallische Überzugsschicht mittels Dampfphasenabscheidung erfolgt.

4. Verfahren nach einem der voranstehenden Ansprüche, **dadurch gekennzeichnet, dass** die erste Überzugsschicht durch Schmelztauchveredelung, elektrolytische oder Dampfphasenabscheidung erzeugt wird.

5. Verfahren nach einem der voranstehenden Ansprüche, **dadurch gekennzeichnet, dass** das Stahlblech aus einem kohlenstoffarmen Stahl besteht.

6. Verfahren nach einem der Ansprüche 2 bis 5, **dadurch gekennzeichnet, dass** im Zuge der thermischen Nachbehandlung eine zusätzliche Legierung der zinkhaltigen Schicht durch Festkörper- und/oder Flüssigphasendiffusion vom Stahlblech her erzeugt wird.

7. Verfahren nach einem der voranstehenden Ansprüche, **dadurch gekennzeichnet, dass** die Erwärmung mittels linearer oder quasi linearer Fokussierung der Strahlungsenergie auf das Material erfolgt.

8. Verfahren nach Anspruch 7, **dadurch gekennzeichnet, dass** der die Strahlungsenergie abgebende Energiestrahl im Wesentlichen senkrecht zur behandelten Oberfläche ausgerichtet wird.

9. Verfahren nach einem der voranstehenden Ansprüche, **dadurch gekennzeichnet, dass** die Wärmebehandlung im Vakuum erfolgt.

10. Verfahren nach einem der voranstehenden Ansprüche, **dadurch gekennzeichnet, dass** die Wärmebehandlung unter einer Schutzgasatmosphäre erfolgt.

11. Verfahren nach einem der Ansprüche 1 bis 10, **dadurch gekennzeichnet, dass** die Wärmebehandlung in einer gezielt reduzierenden bzw. oxidierenden Atmosphäre erfolgt.

12. Verfahren nach einem der voranstehenden Ansprüche, **dadurch gekennzeichnet, dass** die Wärmebehandlung mittels eines Elektronenstrahls erfolgt.

13. Verfahren nach einem Ansprüche 1 bis 11, **dadurch gekennzeichnet, dass** die Wärmebehandlung mittels Laserstrahlung erfolgt.
